Europäisches Patentamt

European Patent Office

Office européen des brevets

(19)

(11) Veröffentlichungsnummer: **0 029 484**
**B1**

(12) # EUROPÄISCHE PATENTSCHRIFT

(45) Veröffentlichungstag der Patentschrift:
17.11.82

(51) Int. Cl.³: **H 01 R 23/70**, H 01 R 23/54

(21) Anmeldenummer: 80104541.0

(22) Anmeldetag: 31.07.80

(54) **Verriegelungs- und Aushebeelement.**

(30) Priorität: 21.11.79 CH 10375/79

(43) Veröffentlichungstag der Anmeldung:
03.06.81 Patentblatt 81/22

(45) Bekanntmachung des Hinweises auf die Patenterteilung:
17.11.82 Patentblatt 82/46

(84) Benannte Vertragsstaaten:
AT BE CH DE FR GB IT LI NL SE

(56) Entgegenhaltungen:
DE-A-1 465 210
DE-A-2 801 427
FR-A-2 385 239
FR-A-2 409 611
US-A-3 451 034
US-A-4 083 616

(73) Patentinhaber: **CONTRAVES AG,**
**Schaffhauserstrasse 580, CH-8052 Zürich (CH)**

(72) Erfinder: **Muther, Franz, Nordstrasse 408,**
**CH-8037 Zürich (CH)**
Erfinder: **Luzzi, Jachen, Bargla 20, CH-7551 Ramosch**
**(CH)**

(74) Vertreter: **Köver, François, Dr. et al, Patentanwälte**
**H.Mitscherlich K. Gunschmann, Dr. W. Körber,**
**J.Schmidt-Evers Steinsdorfstrasse 10,**
**D-8000 München 22 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verriegelungs- und Aushebeelement

Die Erfindung betrifft ein schwenkbar an einer Leiterplatte angeordnetes, einstückiges Verriegelungs- und Aushebeelement zur lösbaren Verriegelung der Leiterplatte mit einem Montagerahmen, bestehend aus einem Griff, zwei im Abstand zueinander angeordneten und durch ein Mittelteil miteinander verbundenen Stegen, welche gabelförmig über die in dem Montagerahmen zu verriegelnde Leiterplatte greifen und durch einen die Leiterplatte sowie die Stege durchdringenden Bolzen mit der Leiterplatte verbunden sind.

Durch die DE-A-2 433 385 ist ein Verriegelungselement bekannt, das an der Querschniene eines Baugruppenträgers angelenkt ist. Am Element ist eine starre Sperrklinke angeordnet, die nach der Betätigung eines Drückers verriegelnd in eine Kerbe einer Schaltungsplatte eingreift. Die Hebel aller Einschubrahmen müssen zur Sicherung gemeinsam mit einer Stange verbunden werden.

Der Erfindung liegt die Aufgabe zugrunde, ein Verriegelungs- und Aushebeelement der eingangs genannten Art zu schaffen, mittels welchem Leiterplatten in einem Montagerahmen vibrations-, schock- und stoßsicher verriegelbar sind und den Anforderungen genügen, die an ein militärtaugliches Gerät gestellt werden. Die Leiterplatte soll ohne zusätzliche Hilfsmittel verriegelt und ausgehoben werden können. Auch sollen für die zu lösenden Aufgaben keine Teile demontiert werden müssen. Ebenfalls soll jede Leiterplatte einzeln im Montagerahmen verriegelt und ausgehoben werden können.

Diese Aufgabe wird dadurch gelöst, daß im Abstand zum Griff an dem Mittelteil ein Sperrnocken und zwischen dem Griff und dem Sperrnocken eine im wesentlichen parallel zu dem Mittelteil verlaufende und am Griff angeformte Sperrzunge vorgesehen ist, und daß im verriegelten Zustand der Sperrnocken in der Ausheberichtung und die Sperrzunge in der Querrichtung an den Montagerahmen stoßen.

Zusätzlich kann das Element zum einfachen und schonenden Ausheben der Leiterplatte verwendet werden. Für eine kostengünstige Herstellung kann das Element im bekannten Spritzverfahren aus Kunststoff hergestellt werden.

Im folgenden wird mit Hilfe der Zeichnung ein Ausführungsbeispiel der Erfindung beschrieben.

Es zeigt

Fig. 1 eine in größerem Maßstab gezeichnete isometrische Darstellung eines an einer Leiterplatte angelenkten und mit einem Montagerahmen im Eingriff stehenden Verriegelungs- und Aushebeelements,

Fig. 2 eine in natürlicher Größe gezeichnete Ansicht des Verriegelungs- und Aushebeelements gemäß Fig. 1, im entriegelten Zustand und in gedrückter Stellung der Sperrzunge,

Fig. 3 einen in größerem Maßstab dargestellten Schnitt durch das Verriegelungs- und Aushebeelement entlang der Linie III-III in Fig. 2.

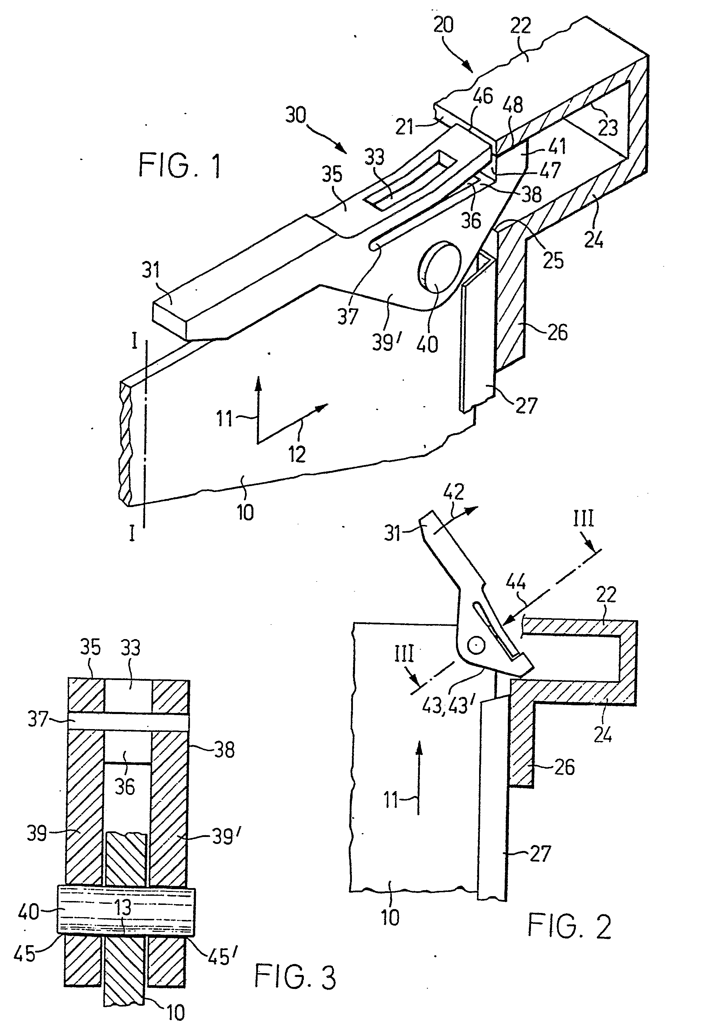

Fig. 1 zeigt eine Leiterplatte 10, die durch ein Verriegelungs- und Aushebeelement 30 mit einem Montagerahmen 20 verriegelt ist. Spiegelsymmetrisch zur Achse I-I ist ein zweites, nicht dargestelltes Verriegelungs- und Aushebeelement an der Leiterplatte angeordnet. Eine am Montagerahmen befestigte Leiterplattenführung 27 stabilisiert die Leiterplatte 10 gegen seitliche Verschiebungen. Eine obere Querschiene 22 und eine untere Querschiene 24 sind über eine Verbindungsschiene 26 mit der Leiterplattenführung 27 in bekannter Weise, zum Beispiel durch Nieten oder Schrauben miteinander verbunden.

Das Verriegelungs- und Aushebeelement ist mit einem Bolzen 40 an der Leiterplatte schwenkbar angelenkt und weist parallel zueinander verlaufende Stege 39, 39' auf, die durch ein Mittelteil 38 miteinander verbunden sind. Die Stege 39, 39' sind soweit voneinander distanziert, daß das Element 30 im entriegelten Zustand um den Bolzen 40 schwenkbar ist. Für den freien Durchgang der Leiterplatte 10 beim Schwenken des Elements 30 sind im Mittelteil 38 sowie in einer im wesentlichen parallel und im Abstand dazu angeordneten Sperrzunge 35 die Ausnehmungen 33 und 36 vorgesehen. Die Sperrzunge ist im wesentlichen an einem Griffteil 31 des Elements 30 federnd angeformt und ist von dem Mittelteil 38 durch einen Spalt 37 getrennt. Der vordere Teil der Sperrzunge 35 ist durch eine Frontfläche 46 begrenzt, die im verriegelten Zustand, wie in Fig. 1 dargestellt, parallel zu einer Anschlagfläche 21 der oberen Querschiene 22 verläuft.

Die Sperrzunge 35 verläuft vom Griff bis zu ihrer Mitte parallel zum Mittelteil und von ihrer Mitte bis zu ihrem freien Ende um einige Grade vom Mittelteil weggebogen.

Wird die Sperrzunge 35, wie in Fig. 2 durch Pfeilrichtung 44 dargestellt, durch einen Druck bis zur Berührung der Oberfläche des Mittelteils 38 gesenkt, so befindet sich die Frontfläche 46 der Sperrzunge 35 annähernd parallel zu der Innenfläche 47 eines im vorderen Bereich des Elements 30 angeformten Sperrnockens 41. Im verriegelten Zustand verläuft eine Frontfläche 48 des Sperrnockens 41 weitgehend parallel zu der Innenfläche 23 der oberen Querschiene 22.

Erfolgt auf die verriegelte Leiterplatte eine Kraftwirkung in Ausheberichtung 11, so erfährt der Sperrnocken 41 mit der Frontfläche 48 einen Anschlag auf die Innenfläche 23 der oberen Querschiene 22. Durch die rückwirkende Kraft entsteht am Element 30 um den Bolzen 40 ein Drehmoment, das einen Anschlag der Frontfläche der Sperrzunge an der Anschlagfläche 21 der oberen Querschiene verursacht. Durch die rückwirkende Kraft des Montagerahmens wird nun eine Drehung des Elements 30 und dadurch ein Ausheben der Leiterplatte verhindert.

In Fig. 2 ist die Wirkungsweise des Elements 30 beim Entriegeln und Ausheben der Leiterplatte 10 aus dem Montagerahmen 20 dargestellt. Nachdem die Sperrzunge 35 bis zur teilweisen Berührung mit dem Mittelteil 38 durch Druck in Pfeilrichtung 44 gesenkt wurde, kann das Element 30 am Griff 31 in Richtung 42 geschwenkt werden. Nach einer Schwenkung um wenige Grade kommen die Stegrücken 43, 43' der beiden Stege 39, 39' mit der Kante 25 der unteren Querschiene 24 in Berührung und heben durch die entstehende Hebelkraft die Leiterplatte 10 in Pfeilrichtung 11 aus dem Montagerahmen 20.

Fig. 3 zeigt einen Schnitt durch das Element 30 entlang der Linie III-III in Fig. 2. Man erkannt den in beiden Bohrungen 45 und 45' der Stege 39, 39' und in der Bohrung 13 der schematisch dargestellten Leiterplatte 10 gelagerten Bolzen 40. Weiterhin ist die im Mittelteil 38 vorgesehene Ausnehmung 36 sowie die in der Sperrzunge 35 vorgesehene Ausnehmung 33 erkennbar, in welche beim Schwenken des Elementes 30 teilweise die Leiterplatte hineinragt.

## Patentansprüche

1. Schwenkbar an einer Leiterplatte (10) angeordnetes, einstückiges Verriegelungs- und Aushebeelement (30) zur lösbaren Verriegelung der Leiterplatte mit einem Montagerahmen (20), bestehend aus einem Griff (31), zwei im Abstand zueinander angeordneten und durch ein Mittelteil (38) miteinander verbundenen Stegen (39, 39'), welche gabelförmig über die in dem Montagerahmen zu verriegelnde Leiterplatte (10) greifen und durch einen die Leiterplatte sowie die Stege durchdringenden Bolzen (40) mit der Leiterplatte verbunden sind, dadurch gekennzeichnet, daß im Abstand zum Griff (31) an dem Mittelteil (38) ein Sperrnocken (41) und zwischen dem Griff und dem Sperrnocken eine im wesentlichen parallel zu dem Mittelteil verlaufende und am Griff angeformte Sperrzunge (35) vorgesehen ist, und daß im verriegelten Zustand der Sperrnocken in der Ausheberichtung (11) und die Sperrzunge in der Querrichtung (12) an den Montagerahmen (20) stoßen.

2. Element nach Anspruch 1, dadurch gekennzeichnet, daß die Sperrzunge (35) federnd angeformt ist.

3. Element nach Anspruch 1, dadurch gekennzeichnet, daß die Sperrzunge (35) vom Griff bis zu ihrer Mitte parallel zum Mittelteil verläuft und von ihrer Mitte bis zu ihrem freien Ende um wenige Grade vom Mittelteil weg gebogen ist.

4. Element nach Anspruch 1, dadurch gekennzeichnet, daß beim Schwenken der Stegrücken (43) auf der Kante (25) einer unteren Querschiene (24) des Montagerahmens (20) aufsteht, so daß durch die entstehende Hebelkraft die Leiterplatte (10) mit geringer Kraft gelöst werden kann.

5. Element nach Anspruch 1, dadurch gekennzeichnet, daß beim vollständigen Einführen der Leiterplatte (10) in den Montagerahmen (20) die Verriegelung selbsttätig erfolgt.

## Claims

1. A one-piece locking- and lifting element (30) disposed in swivelling fashion on a printed circuit board (10), for the releasable locking of the printed circuit board to an assembly frame (20), comprising a grip (31), two limbs (39, 39') connected to one another by a middle portion (38) and arranged at a distance from one another, which limbs engage in forked manner over the printed circuit board (10) that is to be lockes in the assembly frame and are connected to the printed circuit board by a pin (40) penetrating the printed circuit board and the limbs, characterised in that there is provided at a distance from the grip (31) on the middle portion (38) a stop cam (41) and between the grip and the stop cam a stop tongue (35) running substantially parallel to the middle portion and moulded on the grip, and that in the locked state the stop cam abuts against the assembly frame (20) in the lifting direction (11) and the stop tongue abuts it in the transverse direction (12).

2. Element according to claim 1, characterised in that the stop tongue (35) is moulded on in flexible fashion.

3. Element according to claim 1, characterised in that the stop tongue (35) runs parallel to the middle portion from the grip to its middle and is bent away from the middle portion by a few degrees from its middle to its free end.

4. Element according to claim 1, characterised in that on swivelling, the back of the limb (43) rises up on the edge (25) of a lower cross bar (24) of the assembly frame (20) so that with the resultant leverage the printed circuit board (10) can be released with slight force.

5. Element according to claim 1, characterised in that when the printed circuit board (10) is completely inserted into the assembly frame (20), the locking is automatically effected.

## Revendications

1. Elément de verrouillage et d'extraction (30) en une seule pièce, monté pivotant sur une plaque conductrice (10), pour le verrouillage amovible de la plaque conductrice sur un châssis de montage (20), élément se composant d'une poignée (31), de deux pattes (39, 39') distantes l'une de l'autre et reliées par une âme (38), ces pattes venant en forme de fourche par-dessus la plaque conductrice (10) qui est à verrouiller dans le châssis de montage et sont reliées à la plaque conductrice par un goujon (40) traversant la plaque conductrice ainsi que les pattes, élément caractérisé en ce qu'à une certaine distance de la poignée (31), l'âme (38) comporte une came de blocage (41) et entre la poignée et la came de blocage, il y a une languette de blocage (35) essentiellement parallèle à la partie médiane, cette languette étant réalisée sur la poignée, et en ce qu'à l'état verrouillé, la came de blocage et la languette de blocage butent dans la direction d'extraction (11) et dans la direction transversale (12) contre le châssis de montage (20).

2. Elément selon la revendication 1, caractérisé en ce que la languette de blocage (35) est formée de façon élastique.

3. Elément selon la revendication 1, caractérisé en ce que la languette de blocage (35) est parallèle à la partie médiane entre la poignée jusqu'en son milieu et est écartée de quelques degrés par rapport à la partie médiane, entre son milieu jusqu'à son extrémité libre.

4. Elément selon la revendication 1, caractérisé en ce que lors du basculement, le dos (43) des pattes s'appuie sur l'arête (25) du rail transversal (24) inférieur du châssis de montage (20), de sorte que la force des leviers ainsi engendrés détache la plaque conductrice (10) par une faible force.

5. Elément selon la revendication 1, caractérisé en ce que lors de l'introduction complète de la plaque conductrice (10) dans le châssis de montage (20), le verrouillage se fait automatiquement.

FIG. 1

FIG. 2

FIG. 3